# EUROPEAN PATENT SPECIFICATION

(11) **EP 0 675 501 B1**
(45) Date of publication and mention of the grant of the patent: **13.06.2001**
(21) Application number: 94830154.4
(22) Date of filing: 31.03.1994
(51) Int. Cl.: G11C 16/04, G11C 16/06, G11C 14/00

(54) **Non-volatile memory element with double programmable cell and corresponding reading circuit for redundancy circuits**
Nichtflüchtiges Speicherelement mit doppelt programmierbarer Zelle und entsprechende Leseschaltung für Redundanzschaltung
Elément de mémoire non-volatile avec cellule programmable double et circuit de lecture correspondant pour circuits de redondance

(43) Date of publication of application: 04.10.1995
(73) Proprietor: STMicroelectronics S.r.l., 20041 Agrate Brianza (Milano) (IT)
(72) Inventor: Rolandi, Paolo, I-15059 Volpedo (Alessandria) (IT)
(74) Representative: Botti, Mario

(56) References cited:
- WO-A-90/12402
- IEEE JOURNAL OF SOLID-STATE CIRCUITS., vol.24, no.5, October 1989, NEW YORK US pages 1244 - 1249 TERADA ET AL '120-ns 128Kx8-bit/64Kx16-bit CMOS EEPROMs'
- IEEE JOURNAL OF SOLID-STATE CIRCUITS., vol.17, no.5, October 1982, NEW YORK US pages 847 - 851 DONALDSON ET AL 'SNOS 1Kx8 static nonvolatile RAM'
- IEEE INTERNATIONAL SOLID STATE CIRCUITS CONFERENCE., 14 February 1985, NEW YORK US pages 164 - 165 GAW ET AL 'A 100ns 256K CMOS EPROM'

## Description

This invention relates to memory elements for semiconductor non-volatile storage devices, in particular memory elements for redundancy circuits in such devices.

Semiconductor storage devices generally comprise a two-dimensional matrix arrangement of memory elements of the cell type with a field-effect transistor, which elements locate at the intersections of rows (word lines) with columns (bit lines).

In order to write or read elementary information to/from a memory element, one must be able to select the row/column crossing where that memory element locates.

For the purpose, row address signals and column address signals are used which are decoded independently of each other and constitute the so-called "address" of the memory element.

In a monolithically integrated, semiconductor storage device, it often happens that a limited number of memory elements included in the matrix of elements exhibit such faults as may impair their operation.

To avoid that the presence of a few inoperative memory elements may impair the operability of the whole device, it has been known to employ additional memory elements, commonly termed "redundant memory elements", which can be utilized in lieu of memory elements that have been found faulty on testing.

Those circuit parts of the device which are to permit activation and proper connection of such substitutes in the overall operation of the device constitute the so-called "redundancy circuit".

The aggregate of the redundant memory elements and the redundancy circuit parts represent the device "redundancy".

In a storage device, the redundancy circuit comprises programmable non-volatile storage registers which can be used to store address configurations thereinto, corresponding to the locations of the faulty memory elements that are to be cut off from the device operation.

Such registers require to be programmed once, on the occasion of the storage device testing, and are thereafter to retain stored information throughout the device life even in the event of power-offs.

A circuit for programming memory cells in a non-volatile storage register used for the redundancy of a semiconductor storage device is disclosed, for example, in European Patent No. 93830474.8.

As a storage device which includes digital integrated circuits is turned on, or when its operation is resumed after an incidental outage in the power supply, a set of initial operations must be carried out to allow the various elements in the storage device to take predetermined states.

Where no external signals are provided to time such power-on resetting operations, the storage device is provided with an internal arrangement effective to generate initiating pulses for the operations.

The reading of those memory cells which contain information about the addresses of the faulty memory elements to be substituted with redundant elements is a static type, i.e. performed once upon the storage device being turned on, and the information stored in such cells is transferred to a bistable type of storage circuit for storage therein.

However, flip-flops also require that a resetting pulse be supplied upon turning on as well as each time that the supply voltage drops below a value regarded as an acceptable minimum for reliable operation, and then rises again.

In this way, any likelihood of the flip-flops being set to an inappropriate initial state, such as would lead to faulty memory reading, is avoided.

A suitable redundancy circuit for working with resetting pulses is described on IEEE JOURNAL OF SOLID-STATE CIRCUITS, vol. 24, no. 5, October 1989, NEW YORK US pages 1244-1249 TERADA ET AL '120-ns 128Kx8-bit/64Kx16-bit CMOS EEPROMs'.

Well known in the pertinent art are several different power-on resetting circuits, which are also employed in other applications and referred to in literature as Power-On Reset (abbr. POR) circuits, such circuits being effective to detect drops and rises in the supply voltage and generate suitable reset pulses.

In the design of such reset circuits, various requirements are taken account of, such as operation unaffected by variations in the rise characteristic of the supply voltage, minimum required time for a fresh pulse to be generated, and minimum required time for the supply voltage drop to cause a pulse to be generated.

An important requirement of CMOS-type integrated circuits, as are the circuits of storage devices, is that DC consumption should be low while the resetting circuit is in a quiescent or standby state.

The last-mentioned requirement clashes, in a sense, with the previously mentioned ones, and a reasonable static consumption is often accepted in order to provide resetting circuits which are both reliable and better performing from the other aspects.

The underlying technical problem of this invention is to provide a memory element, suitable for use in the non-volatile storage registers of redundancy circuits for storage devices, which has a read circuit with a flip-flop type of circuit doing away with the need for a resetting circuit of the POR type.

This technical problem is solved by a memory element and associated read circuit as previously indicated and defined in the characterizing portions of the appended claims to this specification.

The features and advantages of a memory element with read circuit according to the invention will be apparent from the following description of an embodiment thereof, to be taken by way of example and not of limitation in conjunction with the accompanying drawings.

### In the drawings:

The Figure is a block diagram of a memory element with read circuit according to the invention.

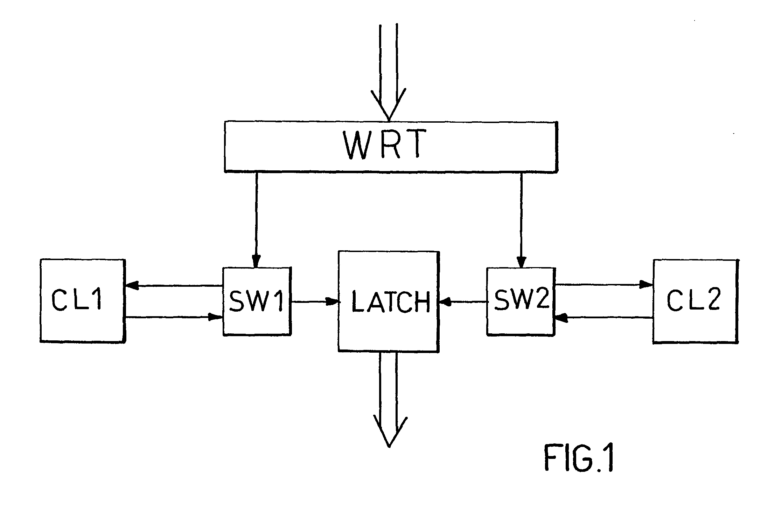

In the block diagram of Figure 1, the memory element is represented by blocks CL1 and CL2. According to the invention, in fact, it comprises a pair of programmable non-volatile memory cells which can be implemented in CMOS technology as field-effect transistor memory cells,

These cells can be programmed, using conventional technologies, by applying appropriate voltages to their terminals.

In accordance with the invention, the read circuit of the memory element further comprises switching circuit elements SW1 and SW2, instead of a POR circuit and additionally to a flip-flop type of circuit LATCH.

Said switching circuit elements are just electronic switches comprised of transistors.

Where the memory elements are used in a redundancy circuit, the switch elements enable a write step during the device testing by closing toward programming circuit means represented by a block WRT.

With the storage device in operation, they would close instead toward the memory cells, to only enable read steps whereby information contained in the memory element is stored into the flip-flop circuit for processing in further circuit sections.

According to the invention, during the write step which may, as mentioned, correspond to the storing of addresses of faulty elements of a memory matrix into registers of redundancy circuits, one cell only is programmed, the other being left deliberately clear.

Unlike the reset circuits, as the device is turned on, the two switching circuit elements become operative directly upon the flip-flop circuit being powered, and their power consumption is zero.

When one of the two memory cells is programmed at a logic "high", upon the device being turned on, it at once will unbalance the flip-flop circuit to a definite state. This is the information which is stored into the flip-flop circuit, regardless of its initial setting, and it can be used by the device processing sections with no possibility for the information in the cells to be altered.

It matters to observe, on the other hand, that the flip-flop circuit, unbalanced by the programmed cell, will unfailingly acknowledge the clear state of the other cell at each power-on.

It will be appreciated that further changes or substitutions are also feasible in ways well known to the skilled ones.

At all events, outstanding is, from the standpoint of designing costs as well, the advantage that no circuit need be provided for resetting upon powering the flip-flop circuit.

## Claims

1. A memory element of the programmable type with a read circuit featuring zero consumption in the quiescent state which comprises a circuit (LATCH) of the bistable type having at least first and second terminals, the memory element comprises first (CL1) and second (CL2) non-volatile memory cells of the programmable type, with the bistable-type circuit being connected between said cells with its first and second terminals and coupled thereto through a first (SW1) and a second (SW2) switching circuit element, respectively, characterized in that the switching elements are operative to connect the first and second memory cells to programming circuit means during a write step, and to the bistable-type circuit during read-only steps.

2. A memory element according to Claim 1, characterized in that at least one of said first and second memory cells is left clear after the write step.

3. A memory element according to either Claim 1 or 2, characterized in that the first and second switching circuit elements are electronic switches.

4. A memory element according to any of the preceding claims, characterized in that the first and second non-volatile memory cells are of the field-effect transistor type.

5. A memory element according to any of the preceding claims, characterized in that the bistable-type circuit comprises first and second inverters connected in a loop, the first and second terminals of that bistable-type circuit being circuit linking nodes between the first and second inverters.

6. A non-volatile storage device of the redundant memory element type, characterized in that it comprises at least one memory element as claimed in any of the preceding claims, employed in a redundancy circuit for the device.

7. A method for storing redundancy address information into a programmable non-volatile storage device, characterized by the use of a pair of memory cells of the non-volatile type, of which at least one is held clear during the write step when the cells are connected to programming sections by switching circuit means, and in that such memory cells are held, during the read-only step, connected to first and second terminals of a bistable-type circuit through said switching circuit means, said bistable-type circuit being coupled to processing sections of the device.

## Patentansprüche

1. Programmierbares Speicherelement mit einer im Ruhezustand keinen Strom verbrauchenden Leseschaltung, welche einen bistabilen Schaltkreis (LATCH) mit mindestens einem ersten und einem zweiten Anschluss aufweist, wobei das Speicherelement eine erste (CL1) und eine zweite (CL2) programmierbare, nicht flüchtige Speicherzelle aufweist, wobei der bistabile Schaltkreis mit seinem ersten und seinem zweiten Anschluss zwischen die Zellen gelegt und damit über ein erstes (SW1) bzw. ein zweites (SW2) Schaltelement gekoppelt ist, dadurch gekennzeichnet, dass die Schaltelemente so arbeiten, dass sie die erste und die zweite Speicherzelle während eines Schreibvorgangs mit Programmier-Schaltungsmitteln, und während Nur-Lese-Schritten mit dem bistabilen Schaltkreis verbinden.

2. Speicherelement nach Anspruch 1, dadurch gekennzeichnet, dass zumindest eine von der ersten und der zweiten Speicherzelle nach dem Schreibvorgang gelöscht bleibt.

3. Speicherelement nach Anspruch 1 oder 2, dadurch gekennzeichnet, dass das erste und das zweite Schaltelement elektronische Schalter sind.

4. Speicherelement nach einem der vorhergehenden Ansprüche, dadurch gekennzeichnet, dass die erste und die zweite nicht-flüchtige Speicherzelle vom Feldeffekttransistor-Typ sind.

5. Speicherelement nach einem der vorhergehenden Ansprüche, dadurch gekennzeichnet, dass der bistabile Schaltkreis einen ersten und einen zweiten Negator in einer Schleife gekoppelt enthält, wobei der erste und der zweite Anschluss des bistabilen Schaltkreises die Schaltungs-Verbindungsknoten zwischen dem ersten und dem zweiten Negator bilden.

6. Nicht-flüchtige Speichereinrichtung vom redundanten Speicherelement-Typ, dadurch gekennzeichnet, dass sie mindestens ein Speicherelement nach einem der vorhergehenden Ansprüche enthält, eingesetzt in einem Redundanz-Schaltungskreis für die Einrichtung.

7. Verfahren zum Speichern von Redundanz-Adressen-Information in einer programmierbaren, nicht-flüchtigen Speichereinrichtung, gekennzeichnet durch die Verwendung eines Paares von Speicherzellen vom nicht-flüchtigen Typ, von denen mindestens eine während des Schreibvorgangs, wenn die Zellen über Schaltmittel an Programmierabschnitte angeschlossen sind, gelöscht bleibt, und dass diese Speicherzellen während des Nur-Lese-Vorgangs an dem ersten und dem zweiten Anschluss eines bistabilen Schaltkreises über die Schalteinrichtung gehalten werden, wobei der bistabile Schaltkreis an die Verarbeitungsabschnitte der Einrichtung gekoppelt ist.

## Revendications

1. Elément de mémoire du type programmable muni d'un circuit de lecture à consommation nulle dans l'état de repos qui comprend un circuit (LATCH) de type bistable ayant au moins des première et seconde bornes, l'élément de mémoire comprenant des première (CL1) et seconde (CL2) cellules mémoire non-volatiles de type programmable, le circuit de type bistable étant connecté entre lesdites cellules par ses première et seconde bornes et étant couplé à celles-ci par l'intermédiaire de premier (SW1) et second (SW2) éléments de circuit de commutation, respectivement, caractérisé en ce que les éléments de commutation agissent pour connecter les première et seconde cellules mémoire au moyen de circuit de programmation pendant une étape d'écriture et au circuit de type bistable pendant des étapes de lecture seulement.

2. Elément de mémoire selon la revendication 1, caractérisé en ce qu'au moins une des première et seconde cellules mémoire est laissée vide après l'étape d'écriture.

3. Elément de mémoire selon la revendication 1 ou 2, caractérisé en ce que les premier et second éléments de circuit de commutation sont des commutateurs électroniques.

4. Elément de mémoire selon l'une quelconque des revendications précédentes, caractérisé en ce que les première et seconde cellules de mémoire non-volatiles sont du type transistor à effet de champ.

5. Elément de mémoire selon l'une quelconque des revendications précédentes, caractérisé en ce que le circuit de type bistable comprend des premier et second inverseurs connectés en une boucle, les première et seconde bornes de ce circuit de type bistable étant des noeuds de liaison du circuit entre les premier et second inverseurs.

6. Dispositif de mémoire non-volatile du type à élément de mémoire redondant, caractérisé en ce qu'il comprend au moins un élément de mémoire selon l'une quelconque des revendications précédentes, utilisé dans un circuit redondant du dispositif.

7. Procédé pour mémoriser des informations d'adresse à redondance dans un dispositif de mémoire non-volatile programmable, caractérisé par l'utilisation de deux cellules mémoire de type non-volatil dont au moins une est maintenue vide pendant l'étape d'écriture quand les cellules sont connectées à des parties de programmation par des moyens de circuit de commutation, et en ce que les cellules mémoire sont maintenues, pendant l'étape de lecture seulement, connectées aux première et seconde bornes d'un circuit de type bistable par l'intermédiaire des moyens de circuit de commutation, le circuit de type bistable étant couplé à des parties de traitement du dispositif.
